# EUROPÄISCHE PATENTANMELDUNG

(11) **EP 2 639 333 A1**
(43) Veröffentlichungstag der Anmeldung: **18.09.2013**
(21) Anmeldenummer: 12159654.8
(22) Anmeldetag: 15.03.2012
(51) Int. Cl.: C23C 18/22

(54) **Verfahren zum Metallisieren nichtleitender Kunststoffoberflächen**

(71) Anmelder: Atotech Deutschland GmbH, 10553 Berlin (DE)
(72) Erfinder: Middeke, Dr. Hermann, 14612 Falkensee (DE); Kuhmeiser, Enrico, 12524 Berlin (DE); Schneider, Steve, 13189 Berlin (DE)
(74) Vertreter: Wonnemann, Jörg

(57) **Zusammenfassung**

Die vorliegende Erfindung betrifft ein Verfahren zur Metallisierung nichtleitender Kunststoffe unter Verwendung einer Beizlösung, die frei von hexavalentem Chrom ist. Die Beizlösung basiert auf einer sauren Permanganatlösung. Nach der Behandlung der Kunststoffe mit der Beizlösung werden die Kunststoffe mittels bekannter Verfahren metallisiert.

## Beschreibung

### Gebiet der Erfindung

Die vorliegende Erfindung betrifft ein Verfahren zum Metallisieren elektrisch nichtleitender Kunststoffoberflächen von Gegenständen unter Verwendung einer Beizlösung, die frei von hexavalentem Chrom ist. Die Beizlösung basiert auf einer Permanganatlösung. Nach der Behandlung mit der Beizlösung können die Gegenstände mittels bekannter Verfahren metallisiert werden.

### Hintergrund der Erfindung

Gegenstände aus elektrisch nichtleitendem Kunststoff können mit einem stromlosen Metallisierungsverfahren metallisiert werden. Bei diesem Verfahren wird der Gegenstand zunächst gereinigt und gebeizt, dann mit einem Edelmetall behandelt und schließlich metallisiert. Die Beizung wird typischerweise mittels Chromschwefelsäure vorgenommen. Die Beizung dient dazu, die Oberfläche des Gegenstandes für die nachfolgende Metallisierung empfänglich zu machen, sodass die Oberflächen der Gegenstände in den nachfolgenden Behandlungsschritten mit den jeweiligen Lösungen gut benetzt werden und das abgeschiedene Metall schließlich auf der Oberfläche ausreichend fest haftet.

Zur Beizung wird die Oberfläche von Gegenständen beispielsweise aus Acrylnitril-Butadien-Styrol-Copolymer (ABS-Copolymer) unter Verwendung von Chromschwefelsäure geätzt, sodass sich oberflächlich Mikrokavernen bilden, in denen sich Metall abscheidet und dort anschließend fest haftet. Im Anschluss an die Beizung wird der Kunststoff für die stromlose Metallisierung mittels eines Aktivators, der ein Edelmetall enthält, aktiviert und danach stromlos metallisiert. Anschließend kann auch eine dickere Metallschicht elektrolytisch aufgebracht werden.

Beizlösungen auf Basis von Chromschwefelsäure sind jedoch toxisch und sollen deshalb möglichst ersetzt werden.

In der Literatur sind Versuche beschrieben, Beizlösungen auf Basis von Chromschwefelsäure durch solche enthaltend Permanganatsalze zu ersetzen.

Die Verwendung von Permanganaten in alkalischem Medium zur Metallisierung von Leiterplatten als Träger elektronischer Schaltungen ist seit langem etabliert. Da die sechswertige Stufe (Manganat), die bei der Oxidation entsteht, wasserlöslich ist und im Alkalischen eine ausreichende Stabilität aufweist, kann das Manganat ähnlich wie auch das dreiwertige Chrom zu dem ursprünglichen Oxidationsmittel, in diesem Fall dem Permanganat, wieder elektrolytisch zurück oxidiert werden. In der Schrift DE 196 11 137 A1 ist die Verwendung des Permanganats auch zur Metallisierung anderer Kunststoffe als Leiterplattenmaterial beschrieben. Für die Metallisierung von ABS-Kunststoffen hat sich eine Lösung aus alkalischem Permanganat als nicht geeignet erwiesen, da auf diese Weise eine verlässliche, ausreichende Haftfestigkeit zwischen Metallschicht und Kunststoffsubstrat nicht erzeugt werden konnte. Diese Haftfestigkeit wird im Streifenabzugstest ("peel test") ermittelt. Sie sollte mindestens einen Wert von 0,4 N/mm aufweisen.

In EP 1 0010 52 ist eine saure Permanganatlösung, die zur Verwendung bei der Kunststoffgalvanisierung geeignet sein soll, offenbart. Die dort beschriebenen Lösungen unterscheiden sich in mehrfacher Hinsicht von der vorliegenden Erfindung, zum Beispiel, weil sie sehr hohe Säurekonzentrationen und sehr geringe Permanganatkonzentrationen verwenden (z.B. 15 M H₂SO₄ und 0,05 M KMn₄). EP 1 0010 52 berichtet nicht über die mit dieser Vorbehandlung erzielbaren Haftfestigkeiten. Eigene Versuche haben gezeigt, dass die Haftfestigkeiten unter einem Wert von 0,4 N/mm liegen. Außerdem sind die in EP 1 0010 52 beschriebenen Lösungen nicht stabil. Eine konstante Qualität der Metallisierung kann deshalb nicht erreicht werden.

Als Alternative zur Chromschwefelsäure werden in WO 2009/023628 A2 stark saure Lösungen enthaltend ein Alkalipermanganat-Salz vorgeschlagen. Die Lösung enthält etwa 20 g/l Alkalipermanganat-Salz in 40 - 85 Gew.-% Phosphorsäure. Solche Lösungen bilden kolloidale Mangan(IV)spezies, die sich schwer abtrennen lassen. Gemäß der WO 2009/023628 A2 führen die Kolloide bereits nach kurzer Zeit dazu, dass eine Beschichtung ausreichender Qualität nicht mehr möglich ist. Zur Lösung des Problems schlägt die WO 2009/023628 A2 vor, Mangan(VII)-Quellen einzusetzen, die keine Alkali- oder Erdalkaliionen enthalten. Die Herstellung solcher Mangan(VII)-Quellen ist jedoch aufwendig.

Nach wie vor wird deshalb die toxische Chromschwefelsäure zur Ätzbehandlung von Kunststoffen eingesetzt.

Für die großtechnische Anwendung der Metallisierung von Kunststoffoberflächen werden die Gegenstände für gewöhnlich an Gestellen befestigt. Dabei handelt es sich um metallene Trägersysteme, die die gleichzeitige Behandlung einer großen Zahl von Gegenständen mit den aufeinanderfolgenden Lösungen der einzelnen Verfahrensschritte sowie letzte Schritte zur elektrolytischen Abscheidung einer oder mehrerer Metallschichten erlauben. Die Gestelle sind in der Regel selbst mit Kunststoff beschichtet. Daher stellen die Gestelle prinzipiell ebenfalls ein Substrat für Metallisierungsverfahren auf Kunststoffoberflächen dar.

Die zusätzliche Metallisierung der Gestelle ist jedoch unerwünscht, da die Metallschichten von den Gestellen nach der Beschichtung der Gegenstände wieder entfernt werden müssen. Dies bedeutet einen zusätzlichen Aufwand für die Entfernung verbunden mit einem zusätzlichen Verbrauch von Chemikalien. Weiter ist die Produktivität der Metallisierungs- anlage in diesem Fall geringer, da die Gestelle vor dem erneuten Bestücken mit Gegenständen erst entmetallisiert werden müssen.

Bei dem Einsatz von chromsäurehaltigen Beizen ist dieses Problem deutlich reduziert. Die Chromsäure dringt während des Beizens auch in die Kunststoffummantelung der Gestelle ein und diffundiert während der nachfolgenden Verfahrensschritte wieder aus dieser hinaus und verhindert so die Metallisierung des Gestells.

Will man also die toxische Chromschwefelsäure zur Ätzbehandlung von Kunststoffen durch ökologisch unbedenkliche Verfahrensschritte ersetzen, ist es vorteilhaft auch die unerwünschte Metallisierung der Gestelle zu verhindern.

Patent DE 195 10 855 C2 beschreibt ein Verfahren zum selektiven oder partiellen elektrolytischen Metallisieren von nichtleitenden Materialien. Dabei wird die gleichzeitige Metallisierung der Gestelle verhindert, indem auf Behandlungsschritte mit adsorptionsfördernden Lösungen, sogenannten Konditionierern, verzichtet wird. Allerdings wird betont, dass das Metallisierungsverfahren von nichtleitenden Materialien in DE 195 10 855 C2 nur zur Direktmetallisierung geeignet ist.

### Beschreibung der Zeichnungen

- Figur 1:: Einfluss der Behandlungsdauer mit Beizlösung auf die Haftfestigkeit
- Figur 2:: Einfluss der Behandlungsdauer von Gegenständen aus einer ABS/PC-Mischung mit Glykolverbindungen auf die Haftfestigkeit
- Figur 3:: Einfluss der Behandlungsdauer von Gegenständen aus ABS mit Glykolverbindungen auf die Haftfestigkeit
- Figur 4:: Zusammenhang zwischen abgelagerter Menge Mangandioxid auf Kunststoffoberflächen und späterer Menge gebundenen Palladiums auf den Kunststoffoberflächen während Verfahrensschritt B), wenn das abgelagerte Mangandioxid zwischenzeitlich in Verfahrensschritt A i) von den Kunststoffoberflächen entfernt wurde.

### Beschreibung der Erfindung

Der vorliegenden Erfindung liegt von daher das Problem zugrunde, dass es bisher nicht möglich ist, mit einer ausreichenden Prozesssicherheit und Haftfestigkeit der nachfolgend aufgebrachten Metallschichten eine Metallisierung von Gegenständen aus elektrisch nichtleitendem Kunststoff auf ökologisch unbedenkliche Weise zu erreichen.

Es besteht daher die Aufgabe, Beizlösungen für elektrisch nichtleitende Kunststoffoberflächen von Gegenständen zu finden, die nicht toxisch sind, jedoch eine ausreichende Haftfestigkeit der aufgebrachten Metallschichten auf der Kunststoffoberfläche liefern.

Diese Aufgabe wird mit dem folgenden erfindungsgemäßen Verfahren gelöst:
Verfahren zum Metallisieren von elektrisch nichtleitenden Kunststoffoberflächen von Gegenständen, umfassend die Verfahrensschritte:
   A) Beizen der Kunststoffoberfläche mit einer Beizlösung,
   B) Behandeln der Kunststoffoberfläche mit einer Lösung eines Metall-Kolloids oder einer Verbindung eines Metalls, wobei das Metall ausgewählt ist aus den Metallen der I. Nebengruppe des Periodensystems der Elemente und der VIII. Nebengruppe des Periodensystems der Elemente, und
   C) Metallisieren der Kunststoffoberfläche mit einer Metallisierungslösung;
dadurch gekennzeichnet, dass die Beizlösung eine Quelle für Permanganationen enthält.

Unter Gegenständen werden im Rahmen dieser Erfindung Gegenstände verstanden, die aus mindestens einem elektrisch nichtleitenden Kunststoff gefertigt sind oder die mit mindestens einer Schicht mindestens eines elektrisch nichtleitenden Kunststoffs bedeckt sind. Die Gegenstände weisen also Oberflächen aus mindestens einem elektrisch nichtleitenden Kunststoff auf. Unter Kunststoffoberflächen werden im Rahmen dieser Erfindung diese besagten Oberflächen der Gegenstände verstanden.

Die Verfahrensschritte der vorliegenden Erfindung werden in der angegebenen Reihenfolge, nicht notwendigerweise aber unmittelbar aufeinander folgend durchgeführt. Es können weitere Verfahrensschritte und zusätzlich jeweils Spülschritte, vorzugsweise mit Wasser, zwischen den Schritten durchgeführt werden.

Durch das erfindungsgemäße Beizen der Kunststoffoberfläche mit einer Beizlösung, enthaltend eine Quelle für Permanganationen (Verfahrensschritt A)), werden höhere Haftfestigkeiten der auf die Kunststoffoberflächen aufzubringenden Metallschicht oder Metallschichten erreicht als mit den bereits bekannten Behandlungen, z.B. mit Chromschwefelsäure. Für das erfindungsgemäße Beizen wird eine Beizlösung eingesetzt, deren Säurekonzentration niedrig und deren Permanganatkonzentration hoch ist. Dadurch kann die Bildung von Mangandioxid-Spezies so eingestellt werden, dass die Stabilität der Beizlösung gewährleistet ist und trotzdem eine ausgezeichnete Haftfestigkeit erzielt wird. Die durch das erfindungsgemäße Beizen erzielte Haftfestigkeit ist auch deutlich höher als mit bekannten Beiz-Verfahren auf der Basis alkalischer Permanganatlösungen oder Beizlösungen mit hoher Säurekonzentration und niedriger Permanganatkonzentration.

Die Kunststoffoberflächen sind aus mindestens einem elektrisch nichtleitenden Kunststoff gefertigt. In einer Ausführungsform der vorliegenden Erfindung wird der mindestens eine elektrisch nichtleitende Kunststoff ausgewählt aus der Gruppe enthaltend ein Acrylnitril-Butadien-Styrol-Copolymer (ABS-Copolymer), ein Polyamid (PA), ein Polycarbonat (PC) und eine Mischung eines ABS-Copolymers mit mindestens einem weiteren Polymer.

In einer bevorzugten Ausführungsform der Erfindung ist der elektrisch nichtleitende Kunststoff ein ABS-Copolymer oder eine Mischung eines ABS-Copolymers mit mindestens einem weiteren Polymer. Besonders bevorzugt ist das mindestens eine weitere Polymer Polycarbonat (PC), das heißt besonders bevorzugt sind ABS/PC-Mischungen.

In einer Ausführungsform der Erfindung kann vor Verfahrensschritt A) folgender weiterer Verfahrensschritt durchgeführt werden:
Behandeln des Gestells mit einer Lösung enthaltend eine Quelle für Iodationen.

Das Behandeln des Gestells mit einer Lösung enthaltend eine Quelle für Iodationen wird im Folgenden auch als Schützen des Gestells bezeichnet. Das Schützen des Gestells kann zu verschiedenen Zeitpunkten während des erfindungsgemäßen Verfahrens stattfinden.

Zu diesem Zeitpunkt sind die Gegenstände noch nicht in dem Gestell befestigt. Das Gestell wird also allein, ohne die Gegenstände, mit der Lösung enthaltend eine Quelle für Iodationen behandelt.

In einer weiteren Ausführungsform der Erfindung kann vor Verfahrensschritt A) folgender weiterer Verfahrensschritt durchgeführt werden:
Befestigen des Gegenstands oder der Gegenstände in einem Gestell.

Dieser weitere Verfahrensschritt wird im Folgenden als Befestigungsschritt bezeichnet. Das Befestigen der Gegenstände in Gestellen ermöglicht die gleichzeitige Behandlung einer großen Zahl von Gegenständen mit den aufeinanderfolgenden Lösungen der einzelnen Verfahrensschritte sowie die elektrische Kontaktierung während der letzten Schritte zur elektrolytischen Abscheidung einer oder mehrerer Metallschichten herzustellen. Die Behandlung der Gegenstände gemäß dem erfindungsgemäßen Verfahren wird vorzugsweise in einem herkömmlichen Tauchverfahren durchgeführt, indem die Gegenstände nacheinander in Lösungen in Behältern eingetaucht werden, in denen die jeweilige Behandlung stattfindet. In diesem Falle können die Gegenstände entweder an Gestellen befestigt oder in Trommeln eingefüllt in die Lösungen eingetaucht werden. Eine Befestigung an Gestellen ist bevorzugt. Die Gestelle sind in der Regel selbst mit Kunststoff beschichtet. Bei dem Kunststoff handelt es sich meist um Polyvinylchlorid (PVC).

In einer weiteren Ausführungsform der Erfindung kann das Schützen des Gestells vor dem Befestigungsschritt durchgeführt werden.

In einer bevorzugten Ausführungsform der Erfindung wird vor dem Verfahrensschritt A) folgender weiterer Verfahrensschritt durchgeführt:
Behandeln der Kunststoffoberfläche in einer wässrigen Lösung enthaltend mindestens eine Glykolverbindung.

Dieser weitere Verfahrensschritt wird im Folgenden als Vorbehandlungsschritt bezeichnet. Durch diesen Vorbehandlungsschritt wird die Haftfestigkeit zwischen dem Kunststoff und der Metallschicht erhöht.

Falls vor Verfahrensschritt A) zusätzlich der Befestigungsschritt durchgeführt wurde, wird der Vorbehandlungsschritt zwischen dem Befestigungsschritt und dem Verfahrensschritt A) durchgeführt.

Unter einer Glykolverbindung werden Verbindungen der folgenden allgemeinen Formel (I) verstanden: 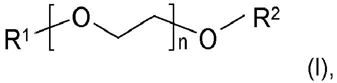 worin
n eine ganze Zahl zwischen 1 und 4 bedeutet; und
R1 und R2 unabhängig voneinander bedeuten -H, -CH₃, -CH₂-CH₃, -CH₂-CH₂-CH₃, -CH(CH₃)-CH₃, -CH₂-CH₂-CH₂-CH₃, -CH(CH₃)-CH₂-CH₃, -CH₂-CH(CH₃)-CH₃, -CH₂-CH₂-CH₂-CH₂-CH₃, -CH(CH₃)-CH₂-CH₂-CH₃, -CH₂-CH(CH₃)-CH₂-CH₃, -CH₂-CH₂-CH(CH₃)-CH₃, -CH(CH₂-CH₃)-CH₂-CH₃, -CH₂-CH(CH₂-CH₃)-CH₃, -CO-CH₃, -CO-CH₂-CH₃, -CO-CH₂-CH₂-CH₃, -CO-CH(CH₃)-CH_{3,} -CO-CH(CH₃)-CH₂-CH₃, -CO-CH₂-CH(CH₃)-CH₃, -CO-CH₂CH₂CH₂CH₃.

Entsprechend der allgemeinen Formel (I) gehören zu den Glykolverbindungen die Glykole selbst sowie Glykolderivate. Zu den Glykolderivaten werden die Glykolether, die Glykolester und die Glykoletherester gerechnet. Bei den Glykolverbindungen handelt es sich um Lösungsmittel.

Bevorzugte Glykolverbindungen sind Ethylenglykol, Diethylenglykol, Ethylenglykolmonomethyletheracetat, Ethylenglykolmonoethyletheracetat, Ethylenglykolmonopropyletheracetat, Ethylenglykolacetat, Diethylenglykolmonoethyletheracetat, Diethylenglykolmonomethyletheracetat, Diethylenglykolmonopropyletheracetat, Butylglykol, Ethylenglykolmonobutylether, Ethylenglykoldiacetat und Mischungen davon. Besonders bevorzugt sind Diethylenglykolmonoethyletheracetat, Ethylenglykolacetat, Ethylenglykoldiacetat, Butylglykol und Mischungen davon.

Bei Verwendung von Glykolestern und Glykoletherestern ist es sinnvoll, den pH-Wert der wässrigen Lösung der Glykolverbindung durch geeignete Maßnahmen im neutralen Bereich zu halten, um die Hydrolyse zum Alkohol und zur Carbonsäure soweit wie möglich zurück zu drängen. Ein Beispiel ist die Hydrolyse des Diethylenglykolmonoethyletheracetats:

CH₃-CO-O-CH₂CH₂-O-CH₂CH₂-O-CH₂CH₃ + H2O → CH₃-COOH + HO-CH₂CH₂-O-CH₂CH₂-O-CH₂CH₃

Die Wasserkonzentration der Lösung enthaltend eine Glykolverbindung hat ebenfalls einen Einfluss auf die Hydrolyse der Glykolester und Glykoletherester. Allerdings muss die Lösung aus zwei Gründen Wasser enthalten: einerseits um eine unbrennbare Behandlungslösung zu erhalten und andererseits, um die Stärke des Angriffs auf die Kunststoffoberfläche einstellen zu können. Ein reines Lösungsmittel, also 100 % einer Glykolverbindung, würde die meisten unvernetzten Polymere auflösen oder mindestens eine unakzeptable Oberfläche hinterlassen. Es hat sich deshalb als sehr vorteilhaft erwiesen, die Lösung eines Glykolesters oder Glykoletheresters zu puffern und so im neutralen pH-Bereich zu halten, was bedeutet, die durch Hydrolyse des Lösungsmittels erzeugten Protonen abzufangen. Ein Phosphatpuffergemisch hat sich dafür als ausreichend geeignet erwiesen. Die gut löslichen Kaliumphosphate erlauben ausreichend hohe Konzentrationen mit guter Pufferkapazität bei Lösungsmittelkonzentrationen bis zu 40% vol.

Die optimale Behandlungsdauer der Kunststoffoberfläche ist abhängig vom verwendeten Kunststoff, der Temperatur sowie der Art und Konzentration der Glykolverbindung. Die Behandlungsparameter haben einen Einfluss auf die Haftung zwischen der behandelten Kunststoffoberfläche und der in nachfolgenden Prozessschritten aufgebrachten Metallschicht. Höhere Temperaturen oder Konzentrationen der Glykolverbindungen beeinflussen ferner die Textur der Kunststoffoberfläche. In jedem Fall sollte es dem nachfolgenden Beizschritt A) möglich sein, das Lösungsmittel wieder aus der Kunststoffmatrix zu entfernen, weil sonst die Folgeschritte des Verfahrens, ganz besonders die Aktivierung gemäß Verfahrensschritt B), gestört werden.

Mit dem erfindungsgemäßen Verfahren werden Haftfestigkeiten von mindestens 0,8 N/mm erhalten, was deutlich über dem geforderten Mindestwert von 0,4 N/mm liegt. Die Behandlungsdauer in dem Vorbehandlungsschritt beträgt zwischen 1 und 30 Minuten, bevorzugt zwischen 5 und 20 Minuten und besonders bevorzugt zwischen 7 bis 15 Minuten.

Die Behandlungstemperatur liegt zwischen 20°C und 70°C, abhängig von der Art des verwendeten Lösungsmittels oder Lösungsmittelgemisches. Bevorzugt ist eine Behandlungstemperatur zwischen 20°C und 50°C, besonders bevorzugt ist eine Behandlungstemperatur zwischen 20°C und 45°C.

Die Behandlung der Kunststoffoberflächen in dem Vorbehandlungsschritt kann in einer wässrigen Lösung enthaltend eine Glykolverbindung durchgeführt werden oder in einer wässrigen Lösung, die zwei oder mehr verschiedene Glykolverbindungen enthält. Die Gesamtkonzentration an Glykolverbindungen in der wässrigen Lösung beträgt 5 % Vol. - 50 % Vol., bevorzugt 10 % Vol. - 40 % Vol. und besonders bevorzugt 20 % Vol. - 40 % Vol. Wenn die besagte Lösung eine Glykolverbindung enthält, entspricht die Gesamtkonzentration der Konzentration dieser einen Glykolverbindung. Wenn die besagte Lösung zwei oder mehr verschiedene Glykolverbindungen enthält, entspricht die Gesamtkonzentration der Summe der Konzentrationen aller enthaltenen Glykolverbindungen. Im Zusammenhang mit der Lösung enthaltend mindestens eine Glykolverbindung ist unter den Konzentrationsangaben für die Glykolverbindung/Glykolverbindungen in % immer eine Konzentration in % Vol. zu verstehen.

So hat sich zur Vorbehandlung von ABS Kunststoffoberflächen eine Lösung von 15% Vol. Diethylenglykolmonoethyletheracetat im Gemisch mit 10% Vol. Butylglykol bei 45°C als vorteilhaft erwiesen (siehe Beispiel 1). Dabei dient das erste Lösungsmittel der Erzeugung der Haftfestigkeit, während das zweite als nichtionisches Tensid die Benetzbarkeit erhöht und dabei hilft, eventuell vorhandene Verschmutzungen von der Kunststoffoberfläche zu entfernen.

Zur Vorbehandlung von ABS/PC-Mischungen, zum Beispiel Bayblend T45 oder Bayblend T65PG, hat sich eine Lösung aus 40% Vol. Diethylenglykolmonoethyletheracetat in Wasser bei Raumtemperatur als vorteilhafter erwiesen, weil sie bei diesen Kunststoffen eine höhere Haftfestigkeit der aufgebrachten Metallschichten erlaubt (siehe Beispiel 2).

In einer weiteren Ausführungsform der Erfindung kann das Schützen des Gestells zwischen dem Befestigungsschritt und dem Vorbehandlungsschritt durchgeführt werden.

In einer weiteren Ausführungsform der Erfindung kann das Schützen des Gestells zwischen dem Vorbehandlungsschritt und dem Verfahrensschritt A) durchgeführt werden.

Zu diesen Zeitpunkten sind die Gegenstände bereits in dem Gestell befestigt. Das Gestell wird also gemeinsam mit den Gegenständen mit der Lösung enthaltend eine Quelle für lodationen behandelt.

Die Formulierungen "das Gestell mit einer Lösung enthaltend eine Quelle für Iodationen behandelt" und "Behandeln des Gestells mit einer Lösung enthaltend eine Quelle für Iodationen" bedeuten im Rahmen dieser Erfindung, dass das Schützen des Gestells allein, ohne die Gegenstände, stattfinden kann (beispielsweise, wenn das Schützen des Gestells vor dem Befestigungsschritt stattfindet) oder dass das Schützen des Gestells gemeinsam mit den Gegenständen stattfinden kann (beispielsweise, wenn das Schützen des Gestells zu irgendeinem Zeitpunkt nach dem Befestigungsschritt stattfindet).

Unabhängig davon, ob das Schützen des Gestells allein oder gemeinsam mit den Gegenständen stattfindet, führt es zu einem Schutz der Kunststoffummantelung der Gestelle vor der Metallabscheidung, während die Gegenstände, die während des Befestigungsschritts in den Gestellen befestigt werden, metallisiert werden. Das Schützen des Gestells sorgt dafür, dass die Kunststoffummantelung der Gestelle in den späteren Verfahrensschritten B) bis C) nicht metallisiert wird, das heißt die Gestelle bleiben frei von Metall. Dieser Effekt ist besonders ausgeprägt auf einer PVC-Ummantelung der Gestelle.

Die erfindungsgemäße Beizbehandlung gemäß Verfahrensschritt A) wird in einer Beizlösung enthaltend eine Quelle für Permanganationen durchgeführt. Die Quelle für Permanganationen wird ausgewählt aus der Gruppe von Alkalimetall-Permanganaten enthaltend Kaliumpermanganat und Natriumpermanganat. Die Quelle für Permanganationen liegt in der Beizlösung in einer Konzentration zwischen 30 g/l und 250 g/l vor, bevorzugt zwischen 30 g/l und 180 g/l, weiter bevorzugt zwischen 90 g/l und 180 g/l und besonders bevorzugt zwischen 90 g/l und 110 g/l. Kaliumpermanganat kann aufgrund seiner Löslichkeit in einer Konzentration von bis zu 70 g/l in der Beizlösung enthalten sein. Natriumpermanganat kann in einer Konzentration von bis zu 250 g/l in der Beizlösung enthalten sein. Die untere Konzentrationsgrenze jedes dieser beiden Salze beträgt typischerweise 30 g/l. Bevorzugt liegt der Gehalt an Natriumpermanganat zwischen 90 g/l und180 g/l.

Die Beizlösung ist bevorzugt sauer, das heißt sie enthält bevorzugt eine Säure. Überraschenderweise sind alkalische Permanganatlösungen, wie sie routinemäßig in der Leiterplattenindustrie als Beizlösung verwendet werden, für die vorliegende Erfindung nicht geeignet, da sie keine ausreichende Haftfestigkeit zwischen Kunststoffoberfläche und Metallschicht bietet.

Säuren, die in der Beizlösung verwendet werden, sind bevorzugt anorganische Säuren. Die anorganische Säure in der Beizlösung gemäß Verfahrensschritt A) wird ausgewählt aus der Gruppe enthaltend Schwefelsäure, Salpetersäure und Phosphorsäure. Die Säurekonzentration darf nicht zu hoch sein, da die Beizlösung andernfalls nicht stabil ist. Die Säurekonzentration beträgt zwischen 0,02 - 0,6 mol/l bezogen auf eine einbasige Säure. Bevorzugt liegt sie zwischen 0,06 und 0,45 mol/l, besonders bevorzugt zwischen 0,07 und 0,30 mol/l jeweils bezogen auf eine einbasige Säure. Bevorzugt wird Schwefelsäure in einer Konzentration zwischen 0,035 und 0,15 mol/l eingesetzt, was einer Säurekonzentration zwischen 0,07 und 0,30 mol/l bezogen auf eine einbasige Säure entspricht.

Die Beizlösung kann bei Temperaturen zwischen 30°C und 90°C, bevorzugt zwischen 55°C bis 75°C betrieben werden. Zwar wurde gefunden, dass ausreichend hohe Haftfestigkeiten zwischen Metallschichten und Kunststoffoberflächen auch bei niedrigen Temperaturen zwischen 30°C und 55°C erzielt werden können. Es kann dann aber nicht sichergestellt werden, dass sämtliches Lösungsmittel der Behandlung mit Glykolverbindung in dem Vorbehandlungsschritt aus der Kunststoffoberfläche entfernt ist. Dies gilt in besonderem Maße für reines ABS. Wenn also der Vorbehandlungsschritt im erfindungsgemäßen Verfahren ausgeführt wird, sind die Temperaturen im nachfolgenden Verfahrensschritt A) höher zu wählen, nämlich im Bereich von 55°C bis 90°C, bevorzugt im Bereich von 55°C bis 75°C. Die optimale Behandlungsdauer hängt von der behandelten Kunststoffoberfläche und der gewählten Temperatur der Beizlösung ab. Für ABS- und ABS/PC- Kunststoffoberflächen wird die beste Haftfestigkeit zwischen Kunststoffoberfläche und anschließend aufgebrachter Metallschicht bei einer Behandlungsdauer zwischen 5 und 30 Minuten erreicht, bevorzugt zwischen 10 und 25 Minuten und besonders bevorzugt zwischen 10 und 15 Minuten. Eine längere Behandlungszeit als 30 Minuten führt in der Regel zu keiner Verbesserung der Haftfestigkeiten mehr.

Eine saure Permanganatlösung ist bei erhöhten Temperaturen, zum Beispiel bei 70°C, sehr reaktiv. Es bilden sich dann durch die Oxidationsreaktion mit der Kunststoffoberfläche viel Mangan(IV)-Spezies, die als Niederschlag ausfallen. Diese Mangan(IV)-Spezies sind überwiegend Mangan(IV)oxide oder Oxidhydrate und werden im Folgenden einfach als Mangandioxid bezeichnet.

Der Mangandioxid-Niederschlag wirkt auf die nachfolgende Metallisierung störend, wenn er auf der Kunststoffoberfläche verbleibt. Er sorgt während des Aktivierens gemäß Verfahrensschritt B) dafür, dass Bereiche der Kunststoffoberfläche nicht mit Metall-Kolloid bedeckt werden oder erzeugt nicht akzeptable Rauheiten der in späteren Verfahrensschritten aufzubringenden Metallschicht.

Das Mangandioxid katalysiert außerdem die Reaktion des Permanganats mit Wasser und kann so zur Instabilität der Beizlösung führen. Die Beizlösung sollte daher vorteilhafterweise frei von Mangandioxid gehalten werden. Überraschenderweise wurde gefunden, dass die Bildung von Mangandioxid-Spezies, die schwer abzutrennen sind, merklich reduziert wird, wenn in der Beizlösung die Säurekonzentration niedrig und die Permanganatkonzentration hoch gewählt ist.

Regelmäßige - in der Regel tägliche - Analyse auf Inhaltsstoffe der Beizlösung ist vorteilhaft, um die Prozesssicherheit zu optimieren. Dazu gehört die Titration der Säure zum Erhalt der ursprünglichen Säurekonzentration und die photometrische Bestimmung der Permanganatkonzentration. Letztere kann mit einem einfachen Photometer erfolgen. Das Licht grüner Leuchtdioden (Wellenlänge λ = 520 nm) entspricht ziemlich genau dem Absorptionsmaximum des Permanganats. Die Verbräuche sind dann entsprechend den analytischen Daten zu ergänzen. Versuche haben gezeigt, dass sich bei der für Verfahrensschritt A) empfohlenen Betriebstemperatur in zehn Minuten Reaktionszeit auf der Oberfläche von ABS Kunststoffen etwa 0,7 g/m² bis 1,2 g/m² Mangandioxid bilden. Verglichen mit den Verlusten durch Ausschleppung von Permanganatlösung durch die Gegenstände ist dieser Verbrauch an die Oberflächenreaktion zu vernachlässigen.

Die erfindungsgemäße Beizlösung enthält kein Chrom oder Chromverbindungen; die Beizlösung enthält weder Chrom(III)ionen noch Chrom(VI)ionen. Die erfindungsgemäße Beizlösung ist also frei von Chrom oder Chromverbindungen; die Beizlösung ist frei von Chrom(III)ionen und Chrom(VI)ionen.

In einer weiteren Ausführungsform werden die Gegenstände im Anschluss an die Permanganatbehandlung gemäß Verfahrensschritt A) durch Abspülen von überschüssiger Permanganatlösung gereinigt. Das Abspülen erfolgt in einem oder mehreren, vorzugsweise drei, Spülschritten mit Wasser.

In einer weiteren bevorzugten Ausführungsform der Erfindung wird zwischen den Verfahrensschritten A) und B) folgender weiterer Verfahrensschritt durchgeführt:
A i) Behandeln der Kunststoffoberfläche in einer Lösung enthaltend ein Reduktionsmittel für Mangandioxid.

Der weitere Verfahrensschritt A i) wird auch als Reduktionsbehandlung bezeichnet. Durch diese Reduktionsbehandlung wird an den Kunststoffoberflächen anhaftendes Mangandioxid zu wasserlöslichen Mangan(II)ionen reduziert. Die Reduktionsbehandlung wird nach der Permanganatbehandlung gemäß Verfahrensschritt A) sowie gegebenenfalls nach dem Abspülen durchgeführt. Hierzu wird eine saure Lösung eines Reduktionsmittels eingesetzt. Das Reduktionsmittel wird ausgewählt aus der Gruppe enthaltend Hydroxylammoniumsulfat, Hydroxylammoniumchlorid und Wasserstoffperoxid. Bevorzugt ist eine saure Lösung von Wasserstoffperoxid, weil Wasserstoffperoxid weder toxisch noch komplexbildend ist. Der Gehalt an Wasserstoffperoxid in der Lösung der Reduktionsbehandlung (Reduktionslösung) beträgt zwischen 25 ml/l und 35 ml/l einer 30%-igen Wasserstoffperoxidlösung (Gew.-%), bevorzugt 30 ml/l einer 30 %-igen Wasserstoffperoxidlösung (Gew.-%).

Als Säure wird in der Reduktionslösung eine anorganische Säure eingesetzt, bevorzugt Schwefelsäure. Die Säurekonzentration beträgt 0,5 mol/l bis 5,0 mol/l, bevorzugt 1,0 mol/l bis 3,0 mol/l, besonders bevorzugt 1,0 mol/l bis 2,0 mol/l jeweils bezogen auf eine einbasige Säure. Bei Verwendung von Schwefelsäure sind Konzentrationen von 50 g/l 96%-iger Schwefelsäure bis 100 g/l 96%-iger Schwefelsäure besonders bevorzugt, was einer Säurekonzentration von 1,0 mol/l bis 2,0 mol/l bezogen auf eine einbasige Säure entspricht.

Durch die Reduktionsbehandlung wird der für die Metallisierung der Gegenstände störend wirkende Mangandioxid-Niederschlag entfernt. Die Reduktionsbehandlung des Verfahrensschritts A i) fördert dadurch die gleichmäßige durchgängige Belegung der Gegenstände mit der gewünschten Metallschicht und fördert die Haftfestigkeit und Glätte der auf die Gegenstände aufgebrachten Metallschicht.

Die Reduktionsbehandlung gemäß Verfahrensschritt A i) wirkt sich ebenfalls vorteilhaft auf die Metallisierung der Kunststoffummantelung des Gestells aus. Die unerwünschte Belegung der Kunststoffummantelung mit Palladium während des Verfahrensschritts B) wird zurückgedrängt. Dieser Effekt ist besonders ausgeprägt, wenn die Reduktionslösung eine starke anorganische Säure, vorzugsweise Schwefelsäure, enthält. Wasserstoffperoxid ist gegenüber Hydroxylammoniumsulfat oder -chlorid in der Reduktionslösung außerdem deshalb bevorzugt, weil es die Gestellmetallisierung besser unterdrückt.

Die Reduktionsbehandlung gemäß Verfahrensschritt A i) wird bei einer Temperatur zwischen 30 °C und 50 °C durchgeführt, bevorzugt bei 40 °C bis 45 °C. Die Reduktionsbehandlung wird für einen Zeitraum zwischen 1 und 10 Minuten durchgeführt, bevorzugt zwischen 3 bis 6 Minuten. Um einen ausreichenden Schutz der Gestelle vor Aktivierung zu erzielen, ist es vorteilhaft, die Behandlungszeit in der Reduktionslösung auf 3 bis 10 Minuten zu erhöhen, bevorzugt auf 3 bis 6 Minuten.

Das verwendete Reduktionsmittel Wasserstoffperoxid muss von Zeit zu Zeit nachdosiert werden. Der Verbrauch von Wasserstoffperoxid lässt sich aus der Menge an auf den Kunststoffoberflächen gebundenem Mangandioxid berechnen. In der Praxis reicht es aus, die Gasenfiivicklung bei der Reduktionsreaktion während Verfahrensschritt A i) zu beobachten und die ursprüngliche Menge an Wasserstoffperoxid, zum Beispiel 30 ml/l einer 30%igen Lösung, zu dosieren, wenn die Gasentwicklung nachlässt. Bei erhöhter Betriebstemperatur der Reduktionslösung, zum Beispiel bei 40°C, ist die Reaktion rasch und nach spätestens einer Minute abgeschlossen.

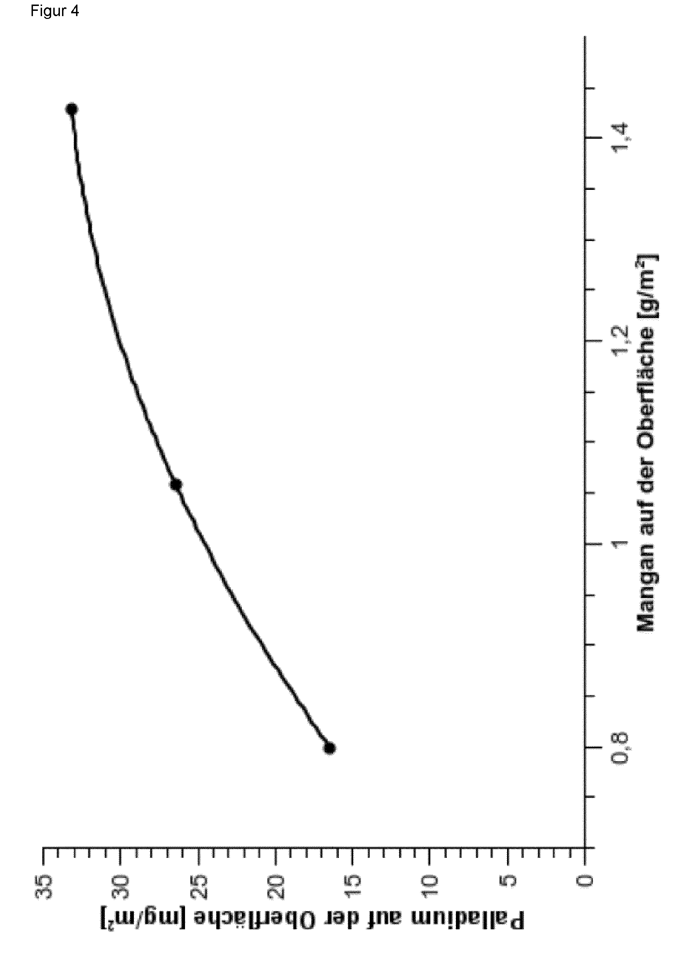

Weiterhin wurde überraschend gefunden, dass bei Ablagerung einer zunehmenden Menge an Mangandioxid auf der Kunststoffoberfläche in Verfahrensschritt A) (Beizen) später beim Aktivieren (Verfahrensschritt B)) die Belegung der Kunststoffoberfläche mit Metall-Kolloid zunimmt, wenn das abgelagerte Mangandioxid zwischenzeitlich in Verfahrensschritt A i) (Reduktionsbehandlung) von der Kunststoffoberfläche entfernt wird. Dieser Zusammenhang ist in Figur 4 dargestellt. Wie im Abschnitt zu Verfahrensschritt A) (Beizen) dargestellt, führen höhere Konzentrationen an Schwefelsäure in der Beizlösung zu der vorteilhaften Ablagerung einer zunehmenden Menge an Mangandioxid auf der Kunststoffoberfläche. Gleichzeitig haben höhere Konzentrationen an Schwefelsäure in der Beizlösung aber auch die nachteiligen Wirkungen, dass die zunehmende Menge an Mangandioxid die Stabilität der Beizlösung deutlich beeinträchtigt und Ablagerungen von Mangandioxid in verstärktem Maße von der Kunststoffoberfläche nach dem Beizen (Verfahrensschritt A)) wieder entfernt werden muss. Die Höhe der Schwefelsäurekonzentration in der Beizlösung führt also zu gegenläufigen Effekten, die sich sowohl positiv als auch negativ auf die Qualität der letztendlich auf die Kunststoffoberfläche aufzubringenden Metallschicht auswirken. Der im Abschnitt zu Verfahrensschritt A) (Beizen) angegebene Konzentrationsbereich der anorganischen Säure und besonders der Schwefelsäure in der Beizlösung stellt damit das Konzentrations-Fenster dar, innerhalb dessen die nachteiligen Wirkungen weitestgehend zurückgedrängt sind, während die vorteilhaften Effekte bestmöglich unterstützt werden.

In einer weiteren Ausführungsform der Erfindung kann das Schützen des Gestells zwischen Verfahrensschritt A) und Verfahrensschritt B) durchgeführt werden, bevorzugt zwischen den Verfahrensschritten A i) und A ii).

Unabhängig davon zu welchem der beschriebenen Zeitpunkte in dem erfindungsgemäßen Verfahren das Schützen des Gestells stattfindet, führt es zu einem Schutz der Kunststoffummantelung der Gestelle vor der Metallabscheidung, während die Gegenstände, die während des Befestigungsschritts in den Gestellen befestigt werden, metallisiert werden.

Die Behandlung mit Iodationen ist besonders vorteilhaft, wenn der Verfahrensschritt B ii) gemäß einer Ausführungsform der Erfindung aus einem stromlosen Metallisieren der Gegenstände in einer Metallisierungslösung besteht.

Die Iodationen sind in wässriger Lösung ausreichend stabil und werden nur durch Ausschleppung verbraucht. Generell steigt die Wirkung des Schützens des Gestells mit steigender Konzentration der Iodationen und mit steigender Betriebstemperatur. Das Schützen des Gestells wird bei einer Temperatur von 20°C bis 70°C ausgeführt, besonders bevorzugt von 45°C bis 55°C. Geeignete Quellen für Iodationen werden ausgewählt aus der Gruppe von Metalliodaten enthaltend Natriumiodat, Kaliumiodat, Magnesiumiodat, Calciumiodat und deren Hydrate. Die Konzentration der Metalliodate beträgt zwischen 5 g/l und 50 g/l, bevorzugt von 15 g/l bis 25 g/l. Die Dauer der Behandlung des Gestells mit Iodationen liegt zwischen 1 bis 20 Minuten, bevorzugt zwischen 2 bis 15 Minuten und besonders bevorzugt zwischen 5 bis 10 Minuten.

Die Lösung enthaltend eine Quelle für Iodationen kann weiter eine Säure enthalten. Bevorzugt sind anorganische Säuren. Die anorganischen Säuren werden ausgewählt aus der Gruppe enthaltend Schwefelsäure und Phosphorsäure, bevorzugt Schwefelsäure. Die Säurekonzentration beträgt 0,02 mol/l bis 2,0 mol/l, bevorzugt 0,06 mol/l bis 1,5 mol/l, besonders bevorzugt 0,1 mol/l bis 1,0 mol/l jeweils bezogen auf eine einbasige Säure. Bei Verwendung von Schwefelsäure sind Konzentrationen von 5 g/l 96%-iger Schwefelsäure bis 50 g/l 96%-iger Schwefelsäure besonders bevorzugt, was einer Säurekonzentration von 0,1 mol/l bis 1,0 mol/l bezogen auf eine einbasige Säure entspricht.

Die beschriebene Zusammensetzung der Lösung enthaltend eine Quelle für Iodationen sowie Temperatur und Dauer der Behandlung des Gestells gelten unabhängig von dem Zeitpunkt im erfindungsgemäßen Verfahren, zu dem das Schützen des Gestells stattfindet.

Weiter zeigt das Behandeln des Gestells mit einer Lösung enthaltend eine Quelle für Iodationen einen Vorratseffekt. Die Wirkung des Schützens der Gestelle, nämlich das Vermeiden der Metallabscheidung auf den Gestellen, hält während eines oder mehrerer Metallisierungszyklen an. Unter einem Metallisierungszyklus wird im Rahmen dieser Erfindung ein Metallisierungsverfahren verstanden, welches gegebenenfalls den Befestigungsschritt, gegebenenfalls den Vorbehandlungsschritt sowie die Verfahrensschritte A) bis C) enthält, aber nicht das Behandeln des Gestells mit einer Lösung enthaltend eine Quelle für Iodationen. In jedem Metallisierungszyklus werden nicht-metallisierte Gegenstände in den Gestellen befestigt und daraus metallisierte Gegenstände erzeugt. Das erfindungsgemäße Verfahren enthaltend das Behandeln des Gestells mit einer Lösung enthaltend eine Quelle für Iodationen wird durchgeführt und anschließend werden ein bis vier Metallisierungszyklen durchgeführt. Während des erfindungsgemäßen Verfahrens und während der Metallisierungszyklen werden Gegenstände metallisiert. Das Gestell wird weder während des erfindungsgemäßen Verfahrens noch während der nachfolgenden Metallisierungszyklen metallisiert, obwohl die Metallisierungszyklen das Behandeln des Gestells mit einer Lösung enthaltend eine Quelle für Iodationen nicht enthalten. Das Behandeln des Gestells mit einer Lösung enthaltend eine Quelle für Iodationen während des erfindungsgemäßen Verfahrens ist ausreichend, um auch während ein bis vier nachfolgender Metallisierungszyklen eine Metallisierung der Gestelle zu vermeiden.

Durch das Behandeln des Gestells mit einer Lösung enthaltend eine Quelle für Iodationen wird das Metallisieren des Gestells vermieden, während die elektrisch nichtleitenden Kunststoffoberflächen von Gegenständen mit Metall überzogen werden. Das Gestell bleibt also während des erfindungsgemäßen Verfahrens frei von Metall. Mit dem erfindungsgemäßen Verfahren ist es nicht notwendig, die Gestelle nach dem Gebrauch wieder vom Metall zu befreien, da die Gestelle durch das erfindungsgemäße Behandeln mit Iodationen nicht metallisiert werden und also von Metall frei bleiben. Die Gestelle können also nach dem Durchführen des Metallisierungsverfahrens und dem Entfernen der metallisierten Gegenstände aus den Gestellen ohne weitere Behandlung unmittelbar wieder in den Produktionskreislauf zurück geführt werden und zur Metallisierung weiterer Gegenstände eingesetzt werden.

Es sind keine zusätzlichen Reinigungs- und Ätzschritte zum Entmetallisieren der Gestelle notwendig. Dadurch wird auch der Aufwand für die Abwasserentsorgung reduziert. Außerdem werden weniger Chemikalien verbraucht. Auch die Produktivität der Metallisierungsanlage wird gesteigert, da bei gegebener Anzahl von vorhandenen Gestellen eine größere Anzahl von zu metallisierenden Gegenständen behandelt werden kann.

Das Verfahren der vorliegenden Erfindung enthält weiter den Verfahrensschritt B), in dem eine Kunststoffoberfläche mit einer Lösung eines Metall-Kolloids oder einer Verbindung eines Metalls behandelt wird.

Das Metall des Metall-Kolloids oder der Metall-Verbindung wird ausgewählt aus der Gruppe enthaltend die Metalle der I. Nebengruppe des Periodensystems der Elemente (PSE) und der VIII. Nebengruppe des PSE.

Das Metall der VIII. Nebengruppe des PSE wird ausgewählt aus der Gruppe enthaltend Palladium, Platin, Iridium, Rhodium und eine Mischung aus zweien oder mehreren dieser Metalle. Das Metall der I. Nebengruppe des PSE wird ausgewählt aus der Gruppe enthaltend Gold, Silber und einer Mischung dieser Metalle.

Als Metall des Metall-Kolloids wird Palladium bevorzugt. Das Metall-Kolloid wird mit einem Schutzkolloid stabilisiert. Das Schutzkolloid wird ausgewählt aus der Gruppe enthaltend metallische Schutzkolloide, organische Schutzkolloide und andere Schutzkolloide. Als metallisches Schutzkolloid werden Zinnionen bevorzugt. Das organische Schutzkolloid wird ausgewählt aus der Gruppe umfassend Polyvinylalkohol, Polyvinylpyrrolidon und Gelatine, bevorzugt ist Polyvinylalkohol.

In einer bevorzugten Ausführungsform der Erfindung ist die Lösung des Metall-Kolloids in Verfahrensschritt B) eine Aktivatorlösung mit einem Palladium/Zinn-Kolloid. Diese Kolloidlösung wird erzeugt aus einem Palladiumsalz, einem Zinn(II)salz und einer anorganischen Säure. Als Palladiumsalz wird Palladiumchlorid bevorzugt. Als Zinn(II)salz wird Zinn(II)chlorid bevorzugt. Die anorganische Säure kann bestehen in Salzsäure oder Schwefelsäure, bevorzugt Salzsäure. Die Kolloidlösung entsteht durch Reduktion des Palladiumchlorids zu Palladium mit Hilfe des Zinn(II)chlorid. Die Umwandlung des Palladiumchlorids in das Kolloid ist vollständig, daher enthält die Kolloidlösung kein Palladiumchlorid mehr. Die Konzentration von Palladium beträgt 5 mg/l - 100 mg/l, bevorzugt 20 mg/l - 50 mg/l und besonders bevorzugt 30 mg/l - 45 mg/l, bezogen auf Pd²⁺. Die Konzentration von Zinn(II)chlorid beträgt 0,5 g/l - 10 g/l, bevorzugt 1 g/l - 5 g/l und besonders bevorzugt 2 g/l - 4 g/l, bezogen auf Sn²⁺. Die Konzentration von Salzsäure beträgt 100 ml/l - 300 ml/l (37 Gew.-% HCl). Außerdem enthält eine Palladium/Zinn-Kolloidlösung zusätzlich Zinn(IV)ionen, die durch Oxidation der Zinn(II)ionen entstehen. Die Temperatur der Kolloidlösung während des Verfahrensschritts B) beträgt 20°C - 50°C und bevorzugt 35°C - 45°C. Die Behandlungsdauer mit der Aktivatorlösung beträgt 0,5 min - 10 min, bevorzugt 2 min - 5 min und besonders bevorzugt 3 min - 5 min.

In einer weiteren Ausführungsform der Erfindung wird in Verfahrensschritt B) die Lösung einer Verbindung eines Metalls an Stelle des Metall-Kolloids eingesetzt. Als Lösung einer Metallverbindung wird eine Lösung verwendet, die eine Säure und ein Metallsalz enthält. Das Metall des Metallsalzes besteht in einem oder mehreren der oben aufgeführten Metalle der I. und VIII. Nebengruppe des PSE. Das Metallsalz kann ein Palladiumsalz sein, vorzugsweise Palladiumchlorid, Palladiumsulfat oder Palladiumacetat, oder ein Silbersalz, vorzugsweise Silberacetat. Die Säure besteht bevorzugt in Salzsäure. Alternativ kann auch ein Metallkomplex eingesetzt werden, beispielsweise ein Palladiumkomplexsalz, wie ein Salz eines Palladium-Aminopyridin-Komplexes. Die Metallverbindung liegt in Verfahrensschritt B) in einer Konzentration von 40 mg/l bis 80 mg/l, bezogen auf das Metall vor. Die Lösung der Metallverbindung kann bei einer Temperatur von 25°C bis 70°C betrieben werden, bevorzugt bei 25°C. Die Behandlungsdauer mit der Lösung einer Metallverbindung beträgt 0,5 min - 10 min, bevorzugt 2 min - 6 min und besonders bevorzugt 3 min - 5 min. Zwischen den Verfahrensschritten A) und B) kann folgender weiterer Verfahrensschritt durchgeführt werden:
A ii) Behandeln der Kunststoffoberfläche in einer wässrigen sauren Lösung.

Bevorzugt wird Verfahrensschritt A ii) zwischen den Verfahrensschritten A i) und B) durchgeführt. Wenn sich im erfindungsgemäßen Verfahren an Verfahrensschritt A i) das Schützen der Gestelle anschloss, wird Verfahrensschritt A ii) besonders bevorzugt zwischen dem Schützen der Gestelle und Verfahrensschritt B) durchgeführt.

Das Behandeln der Kunststoffoberflächen gemäß Verfahrensschritt A ii) wird auch als Vortauchen bezeichnet und die eingesetzte wässrige saure Lösung als Vortauchlösung. Die Vortauchlösung hat dieselbe Zusammensetzung wie die Kolloidlösung in Verfahrensschritt B), ohne dass das Metall des Kolloids und dessen Schutzkolloid enthalten sind. Die Vortauchlösung enthält im Falle des Einsetzens einer Palladium/Zinn-Kolloidlösung in Verfahrensschritt B) ausschließlich Salzsäure, wenn die Kolloidlösung ebenfalls Salzsäure enthält. Zum Vortauchen reicht ein kurzes Eintauchen in die Vortauchlösung bei Umgebungstemperatur aus. Ohne die Kunststoffoberflächen zu spülen, werden diese nach der Behandlung in der Vortauchlösung direkt mit der Kolloidlösung des Verfahrensschritts B) weiter behandelt.

Verfahrensschritt A ii) wird bevorzugt durchgeführt, wenn Verfahrensschritt B) in dem Behandeln einer Kunststoffoberfläche mit einer Lösung eines Metall-Kolloids besteht. Verfahrensschritt A ii) kann auch durchgeführt werden, wenn Verfahrensschritt B) in dem Behandeln einer Kunststoffoberfläche mit einer Lösung einer Verbindung eines Metalls besteht.

Nach der Behandlung der Kunststoffoberflächen mit dem Metall-Kolloid oder der Metallverbindung gemäß Verfahrensschritt B) können diese gespült werden.

In einer weiteren Ausführungsform der Erfindung werden zwischen den Verfahrensschritten B) und C) folgende weitere Verfahrensschritte durchgeführt:
B i) Behandeln der Kunststoffoberfläche in einer wässrigen sauren Lösung und
B ii) Stromloses Metallisieren der Kunststoffoberfläche in einer Metallisierungslösung.

Die Ausführungsform ist in Tabelle 1 schematisch dargestellt.

**Tabelle 1: Ausführungsform der Kunststoffmetallisierung**

| **Verfahrensschritt** | **Inhaltsstoffe** | **Dauer** | **Temperatur** |
|---|---|---|---|
| A) Beizen | 100 g/l Natriumpermanganat, 10 g/l 96%-iger Schwefelsäure | 5-15 min | 70°C |
| A i) Reduzieren | 100 g/l 96%-iger Schwefelsäure, 30ml/l Wasserstoffperoxid, 30 Gew.% | 1 min | 45°C |
| A ii) Vortauchen | Salzsäure, etwa 10 Gew.% | 1 min | 20°C |
| B) Aktivieren | Salzsaures Palladium / Zinn Kolloid | 3-6 min | 20-45°C |
| B i) Beschleunigen | Schwefelsäure (5%) | 2-6 min | 40-50°C |
| B ii) stromlos Metall abscheiden | Chemisch reduktive Vernickelung oder Verkupferung | 6-20 min | 30-50°C |
| C) Metall abscheiden | Zum Beispiel elektrochemisches Verkupfern oder Vernickeln | 15-70 min | 20-35°C |

Diese weiteren Verfahrensschritte B i) und B ii) werden dann angewendet, wenn die Gegenstände mit einem stromlosen Metallisierungsverfahren metallisiert werden sollen, das heißt dass eine erste Metallschicht mit einem stromlosen Verfahren auf die Kunststoffoberflächen aufgebracht werden soll.

Wenn in Verfahrensschritt B) die Aktivierung mit einem Metall-Kolloid durchgeführt wurde, werden in Verfahrensschritt B i) die Kunststoffoberflächen mit einer Beschleunigerlösung behandelt, um Bestandteile des Kolloids der Kolloidlösung, beispielsweise eines Schutzkolloids, von den Kunststoffoberflächen zu entfernen. Falls das Kolloid der Kolloidlösung gemäß Verfahrensschritt B) ein Palladium/Zinn-Kolloid ist, wird als Beschleunigerlösung vorzugsweise eine wässrige Lösung einer Säure verwendet. Die Säure wird beispielsweise ausgewählt aus der Gruppe enthaltend Schwefelsäure, Salzsäure, Citronensäure und Tetrafluoroborsäure. Im Fall eines Palladium/Zinn-Kolloids werden mit Hilfe der Beschleunigerlösung die Zinnverbindungen entfernt, welche als Schutzkolloid dienten.

Alternativ wird in Verfahrensschritt B i) eine Reduktorbehandlung durchgeführt, wenn in Verfahrensschritt B) für die Aktivierung eine Lösung einer Metallverbindung an Stelle eines Metall-Kolloids eingesetzt wurde. Die dazu verwendete Reduktorlösung enthält dann, wenn die Lösung der Metallverbindung in einer salzsauren Lösung von Palladiumchlorid oder einer sauren Lösung eines Silbersalzes bestand, Salzsäure und Zinn(II)chlorid. Die Reduktorlösung kann auch ein anderes Reduktionsmittel enthalten, wie NaH₂PO₂ oder auch ein Boran oder Borhydrid, wie ein Alkali- oder Erdalkaliboran oder Dimethylaminoboran. Bevorzugt wird in der Reduktorlösung NaH₂PO₂ eingesetzt. Nach der Beschleunigung oder Behandlung mit der Reduktorlösung gemäß Verfahrensschritt B i) können die Kunststoffoberflächen zunächst gespült werden.

Verfahrensschritt B i) und gegebenenfalls ein oder mehrere Spülschritte werden von Verfahrensschritt B ii) gefolgt, in dem die Kunststoffoberflächen stromlos metallisiert werden. Zum stromlosen Vernickeln dient beispielsweise ein herkömmliches Nickelbad, das unter anderem Nickelsulfat, ein Hypophosphit, beispielsweise Natriumhypophosphit, als Reduktionsmittel sowie organische Komplexbildner und pH-Einstellmittel (beispielsweise einen Puffer) enthält. Als Reduktionsmittel können ebenfalls Dimethylaminoboran oder ein Gemisch aus Hypophosphit und Dimethylaminoboran eingesetzt werden.

Alternativ kann zum stromlosen Verkupfern ein stromloses Kupferbad eingesetzt werden, das typischerweise ein Kupfersalz, beispielsweise Kupfersulfat oder Kupferhypophosphit, ferner ein Reduktionsmittel, wie Formaldehyd oder ein Hypophosphitsalz, beispielsweise ein Alkali- oder Ammoniumsalz, oder hypophosphorige Säure, ferner einen oder mehrere Komplexbildner, wie Weinsäure, sowie ein pH-Einstellmittel, wie Natriumhydroxid, enthält.

Die so leitfähig gemachte Oberfläche kann anschließend elektrolytisch weiter metallisiert werden, um eine funktionelle oder dekorative Oberfläche zu erhalten.

Schritt C) des erfindungsgemäßen Verfahrens ist das Metallisieren der Kunststoffoberfläche mit einer Metallisierungslösung. Das Metallisieren gemäß Verfahrensschritt C) kann elektrolytisch erfolgen. Zur elektrolytischen Metallisierung können beliebige Metallabscheidungsbäder eingesetzt werden, beispielsweise zur Abscheidung von Nickel, Kupfer, Silber, Gold, Zinn, Zink, Eisen, Blei oder von deren Legierungen. Derartige Abscheidungsbäder sind dem Fachmann geläufig. Als Glanznickelbad wird typischerweise ein Watts-Nickelbad eingesetzt, das Nickelsulfat, Nickelchlorid und Borsäure sowie Saccharin als Additiv enthält. Als Glanzkupferbad wird beispielsweise eine Zusammensetzung verwendet, die Kupfersulfat, Schwefelsäure, Natriumchlorid sowie organische Schwefelverbindungen, in denen der Schwefel in einer niedrigen Oxidationsstufe vorliegt, beispielsweise organische Sulfide oder Disulfide, als Additive enthält.

Das Metallisieren der Kunststoffoberfläche in Verfahrensschritt C) führt dazu, dass die Kunststoffoberfläche mit Metall überzogen wird, wobei das Metall ausgewählt ist aus den oben aufgeführten Metallen für die Abscheidungsbäder.

In einer weiteren Ausführungsform der Erfindung wird nach Verfahrensschritt C) folgender weiterer Verfahrensschritt durchgeführt:
C i) Lagern der metallisierten Kunststoffoberfläche bei erhöhter Temperatur.

Wie bei allen galvanischen Prozessen, in denen ein Nichtleiter nasschemisch mit Metall beschichtet wird, nimmt in der ersten Zeit nach dem Aufbringen der Metallschicht die Haftfestigkeit zwischen Metall und Kunststoff-Substrat zu. Bei Raumtemperatur ist dieser Vorgang nach etwa drei Tagen abgeschlossen. Das lässt sich durch Lagerung bei erhöhter Temperatur erheblich beschleunigen. Der Vorgang ist bei 80°C nach etwa einer Stunde abgeschlossen. Es wird angenommen, dass die zunächst geringe Haftfestigkeit durch eine dünne Wasserschicht verursacht wird, die an der Grenzschicht zwischen Metall und nichtleitendem Substrat liegt und die Ausbildung elektrostatischer Kräfte behindert.

Es wurde gefunden, dass das erfindungsgemäße Beizen mit Permanganatlösung (Verfahrensschritt A)) eine Struktur der Kunststoffoberfläche erzeugt, die eine größere Kontaktfläche des Kunststoffs mit der Metallschicht erlaubt als beispielsweise eine konventionelle Vorbehandlung mit Chromschwefelsäure. Das ist auch der Grund dafür, dass im Vergleich zur Behandlung mit Chromschwefelsäure höhere Haftfestigkeiten erreicht werden (siehe Beispiele 2 und 3). Die glattere Oberfläche bietet aber direkt nach der Metallisierung bisweilen eine noch geringere anfängliche Haftfestigkeit als dies bei der Verwendung von Chromschwefelsäure der Fall ist. Insbesondere bei der galvanischen Vernickelung und ganz besonders, wenn die abgeschiedenen Metallschichten hohe innere Spannungen aufweisen oder wenn die thermischen Ausdehnungskoeffizienten von Metall und Kunststoff stark unterschiedlich sind und der Verbund rasch wechselnden Temperaturen ausgesetzt wird, kann die anfängliche Haftfestigkeit nicht ausreichend sein.

Dann ist das Behandeln der metallisierten Kunststoffoberflächen bei erhöhter Temperatur vorteilhaft. Ein solcher Schritt kann darin bestehen, einen metallisierten Gegenstand aus ABS-Kunststoff für einen Zeitraum zwischen 5 Minuten und 60 Minuten bei erhöhter Temperatur im Bereich von 50°C bis 80°C, zu behandeln, bevorzugt bei einer Temperatur von 70°C, in einem Wasserbad, damit sich das Wasser an der Grenzschicht Metall - Kunststoff in der Kunststoffmatrix verteilen kann. Das Behandeln oder Lagern der metallisierten Kunststoffoberflächen bei erhöhter Temperatur führt dazu, dass eine anfängliche, geringere Haftfestigkeit weiter verstärkt wird, so dass nach dem Verfahrensschritt C i) eine Haftfestigkeit der auf die Kunststoffoberfläche aufgebrachten Metallschicht erreicht wird, die im gewünschten Bereich von mindestens oder größer als 0,8 N/mm liegt.

Das erfindungsgemäße Verfahren ermöglicht also mit guter Prozesssicherheit und ausgezeichneter Haftfestigkeit der nachfolgend aufgebrachten Metallschichten eine Metallisierung von elektrisch nichtleitenden Kunststoffoberflächen von Gegenständen zu erreichen. Die Haftfestigkeit der auf Kunststoffoberflächen aufgebrachten Metallschichten erreicht dabei Werte von 0,8 N/mm und höher. Damit liegen die erzielten Haftfestigkeiten auch deutlich über denen, die gemäß des Stands der Technik nach Beizung von Kunststoffoberflächen mit Chromschwefelsäure erhalten werden können (siehe Beispiele 2 und 3). Darüber hinaus werden nicht nur planare Kunststoffoberflächen durch das erfindungsgemäße Verfahren mit hoher Haftfestigkeit metallisiert, sondern auch ungleichmäßig geformte Kunststoffoberflächen, wie z.B. Duschbrausen, werden mit einer gleichmäßigen und haftfesten Metallbeschichtung versehen.

Die Behandlung der Kunststoffoberflächen gemäß dem erfindungsgemäßen Verfahren wird vorzugsweise in einem herkömmlichen Tauchverfahren durchgeführt, indem die Gegenstände nacheinander in Lösungen in Behälter eingetaucht werden, in denen die jeweilige Behandlung stattfindet. In diesem Falle können die Gegenstände entweder an Gestellen befestigt oder in Trommeln eingefüllt in die Lösungen eingetaucht werden. Eine Befestigung an Gestellen ist bevorzugt. Alternativ können die Gegenstände auch in so genannten Durchlaufanlagen, indem sie beispielsweise auf Horden liegen und in horizontaler Richtung kontinuierlich durch die Anlagen befördert werden, behandelt werden.

### Ausführungsbeispiele

Die nachfolgend beschriebenen Ausführungsbeispiele sollen die Erfindung näher erläutern.

### Beispiel 1: erfindungsgemäßes Beispiel

Eine Platte aus ABS Kunststoff (Novodur P2MC, Fa. Ineos) mit den Abmessungen 5,2 cm x 14,9 cm x 3 mm wurde an einem Draht aus Edelstahl befestigt. Die Platte wurde zehn Minuten lang in eine Lösung aus 15 % 2-(2-Ethoxyethoxy)-ethylacetat und 10 % Butoxyethanol getaucht, die mit einem Kaliumphosphatpuffer auf pH = 7 eingestellt war, und in einem Thermostaten bei 45 °C gehalten wurde (Vorbehandlungsschritt). Anschließend wurde die Platte etwa eine Minute lang unter fließendem Wasser abgespült und dann in ein Bad aus 100 g/l Natriumpermanganat sowie 10 g/l 96%-iger Schwefelsäure gebracht, das bei 70°C gehalten wurde (Verfahrensschritt A)). Nach einer Behandlungsdauer von zehn Minuten wurde wieder eine Minute lang unter Wasser gespült und die nun dunkelbraune Platte in einer Lösung aus 50 g/l 96%-iger Schwefelsäure und 30 ml/l 30 %-igem Wasserstoffperoxid von abgeschiedenem Braunstein gereinigt (Verfahrensschritt A i)). Nach anschließendem Spülen und kurzem Tauchen in eine Lösung aus 300 ml/l 36 %-iger Salzsäure (Verfahrensschritt A ii)) wurde die Platte drei Minuten lang in einem kolloidalen Aktivator auf Basis eines Palladiumkolloids (Adhemax Aktivator PL der Fa. Atotech, 25 ppm Palladium) bei 45 °C aktiviert (Verfahrensschritt B)).

Nach anschließendem Spülen wurden fünf Minuten lang bei 50 °C die Schutzhüllen der Palladiumpartikel entfernt (Adhemax Beschleuniger ACC1 der Fa. Atotech, Verfahrensschritt B i)). Die Platte wurde anschließend zehn Minuten lang außenstromlos vernickelt (Adhemax LFS, Fa. Atotech, Verfahrensschritt B ii)) bei 45 °C, gespült und bei 3,5 A/dm² 70 Minuten lang bei Raumtemperatur verkupfert (Cupracid HT, Fa. Atotech, Verfahrensschritt C)). Nach dem Spülen wurde die Platte 30 Minuten lang bei 80 °C gelagert (Verfahrensschritt C i)). Anschließend wurde mit einem Messer ein etwa 1 cm breiter Streifen der metallisierten Kunststoffplatte ausgeschnitten und mit einer Zugprüfmaschine (Fa. Instron) die Metallschicht vom Kunststoff abgezogen (ASTM B 533 1985 Reapproved 2009). Es wurde eine Haftfestigkeit von 1,97 N/mm gefunden.

Die Abfolge der Verfahrensschritte in Beispiel 1 ist in Tabelle 2 zusammengefasst.

**Tabelle 2: Abfolge der Verfahrensschritte in Beispiel 1**

| **Verfahrensschritt** | **Chemie** | **Dauer** | **Temperatur** |
|---|---|---|---|
| Vorbehandeln | 15 % 2-(2-Ethoxyethoxy)-ethylacetat und 10 % Butoxyethanol in Wasser, Kaliumphosphat-puffer, pH = 7 | 10 min | 45°C |
| A) Beizen | 100 g/l Natriumpermanganat, 10 g/l 96%-iger Schwefelsäure | 10 min | 70°C |
| A i) Reduzieren | 50 g/l 96%-iger Schwefelsäure, 30ml/l Wasserstoffperoxid, 30 Gew.% | 1 min | 45°C |
| A ii) Vortauchen | Salzsäure, 10 Gew.% | 1 min | 20°C |
| B) Aktivieren | Palladiumkolloid, 25 ppm Palladium | 3 min | 45°C |
| B i) Beschleunigen | Schwefelsäure 5% | 5 min | 50°C |
| B ii) stromlos Metall abscheiden | Chemisch reduktive Vernickelung, Adhemax LFS, Fa. Atotech | 10 min | 45°C |
| C) Elektrolytisch Metall abscheiden | elektrochemisches Verkupfern, Cupracid HT, Fa. Atotech, 3,5 A/dm² | 70 min | 21°C |
| C i) Lagern | --- | 30 min | 80 °C |

### Beispiel 2: Vergleichs-Experiment

Vier Platten aus Bayblend T45 (5,2 x 14,9 x 0,3 cm, ABS/PC-Mischung) wurden in einer 40 %-igen Lösung aus 2-(2-Ethoxyethoxy)-ethylacetat zehn Minuten lang bei Raumtemperatur behandelt. Zwei Platten wurden nach dem Abspülen, wie in Beispiel 1 beschrieben, mit einer warmen (70 °C) sauren Permanganatlösung behandelt, die 100 g/l Natriumpermanganat und 10 g/l 96%-iger Schwefelsäure enthielt (erfindungsgemäße Beizlösung I, Endkonzentration: 0,1 mol/l Schwefelsäure). Die anderen beiden Platten wurden unter denselben Bedingungen in einer analogen Permanganatlösung behandelt, die 100 g/l 96%-iger Schwefelsäure enthielt (Beizlösung II mit höherer Schwefelsäurekonzentration als in erfindungsgemäßen Beizlösungen, Endkonzentration: 1 mol/l Schwefelsäure). Nach der Behandlung war die Oberfläche der Platten, die mit Beizlösung II behandelt wurden, wesentlich dunkler als die der Platten, die mit der Beizlösung I mit nur 10 g/l 96%-iger Schwefelsäure behandelt worden war. Die Beizlösung II mit dem höheren Schwefelsäuregehalt entwickelte bei ihrer Betriebstemperatur (70 °C) relativ viel Sauerstoff. Nach dem Abkühlen der Beizlösung II wurden in einem Liter etwa 50 ml Mangandioxidschlamm gefunden. In Beizlösung I dagegen wurde kein Mangandioxidschlamm gefunden.

Alle vier Platten wurden reduktiv vom Braunstein befreit, aktiviert (25 ppm Palladium) und schließlich reduktiv vernickelt und galvanisch verkupfert (Verfahrensschritte A i) bis C) wie in Beispiel 1). Es wurden die folgenden Haftfestigkeiten gefunden:
Platten mit Beizlösung I behandelt:

| | | |
|---|---|---|
| Platte 1 | Vorderseite: 1,09 N/mm. | Rückseite: 1,27 N/mm |
| Platte 2 | Vorderseite: 1,30 N/mm. | Rückseite: 1,32 N/mm |

Platten mit Beizlösung II behandelt:

| | | |
|---|---|---|
| Platte 3 | Vorderseite: 1,19 N/mm. | Rückseite: 1,10 N/mm |
| Platte 4 | Vorderseite: 1,07 N/mm. | Rückseite: 1,25 N/mm |

Die Haftfestigkeiten der Platten unterscheiden sich geringfügig voneinander. Im Konzentrationsbereich zwischen 10 g/l 96%-iger Schwefelsäure und 100 g/l 96%-iger Schwefelsäure hat ein erhöhter Schwefelsäuregehalt einen geringen Einfluss auf die Haftfestigkeit der Metallschicht auf der Kunststoffoberfläche. Wie an der signifikant höheren Menge an entstandenem Mangandioxid abgelesen werden kann, führt der höhere Schwefelsäuregehalt von Beizlösung II jedoch bereits zu geringerer Stabilität der Beizlösung.

### Beispiel 3: Vergleichs-Experiment

Vier Platten aus Bayblend T45 (5,2 x 14,9 x 0,3 cm, ABS/PC-Mischung) wurden behandelt, wie in Beispiel 2 beschrieben. Das Beizen (Verfahrensschritt A)) wurde jedoch unter anderen Bedingungen durchgeführt als in Beispiel 2 angegeben.

Zwei der vier Platten wurden mit Beizlösung III (Chromschwefelsäurelösung aus dem Stand der Technik) behandelt, welche aus 380 g/l Chrom(VI)oxid und 380 g/l konzentrierter Schwefelsäure bestand. Die Beiz-Behandlung wurde für zehn Minuten bei 70 °C durchgeführt.

Die anderen beiden Platten wurden mit Beizlösung IV (alkalische Permanganatlösung aus dem Stand der Technik) behandelt, welche aus 30 g/l Natriumpermanganat und 20 g/l Natriumhydroxid bestand. Die Beiz-Behandlung wurde für zehn Minuten bei 70 °C durchgeführt.

Für Platten, die mit Beizlösung III behandelt wurden, wurden Haftfestigkeiten zwischen 0,45 N/mm und 0,70 N/mm gefunden und für Platten, die mit Beizlösung IV behandelt wurden, Haftfestigkeiten zwischen 0 N/mm (Blasen zwischen Metallschicht und Kunststoffoberfläche) und 0,25 N/mm. Im Vergleich dazu wurden für Platten, die mit der erfindungsgemäßen Beizlösung (Beizlösung I, siehe Beispiel 2) behandelt wurden, deutlich bessere Haftfestigkeiten zwischen 1,09 N/mm und 1,32 N/mm gefunden.

### Beispiel 4: erfindungsgemäßes Beispiel

Platten aus Bayblend T45 (5,2 x 14,9 x 0,3 cm, ABS/PC-Mischung) wurden in einer 40 %-igen Lösung aus 2-(2-Ethoxyethoxy)-ethylacetat zehn Minuten lang bei Raumtemperatur behandelt. Die Platten wurden nach dem Abspülen, wie in Beispiel 1 beschrieben, mit einer warmen (70 °C) sauren Permanganatlösung behandelt, die 100 g/l Natriumpermanganat und 10 g/l 96%-iger Schwefelsäure enthielt. Dabei wurde die Behandlungsdauer in der sauren Permanganatlösung variiert. Die Platten wurden danach reduktiv vom Braunstein befreit, aktiviert (Aktivator mit 25 ppm Palladium), reduktiv vernickelt und galvanisch verkupfert (Verfahrensschritte A i) bis C) wie in Beispiel 1). Anschließend wurden die Haftfestigkeiten für die unterschiedlich lange mit der Beizlösung behandelten Platten bestimmt.

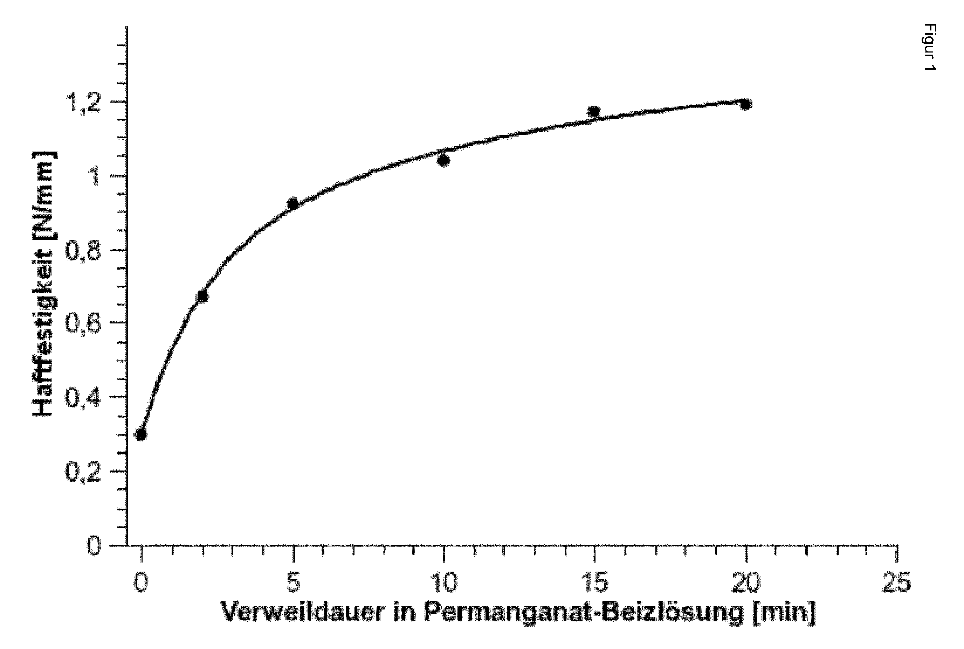

Figur 1 zeigt die Haftfestigkeiten in Abhängigkeit von der Länge der Behandlung in der Beizlösung. Für Platten aus Bayblend T45 wird bereits nach einer Behandlungsdauer (in Figur 1 als Verweildauer bezeichnet) zwischen 5 bis 10 Minuten eine sehr gute Haftfestigkeit von 1 N/mm erreicht.

### Beispiel 5: erfindungsgemäßes Beispiel

Platten von in Beispiel 1 beschriebener Größe aus den Kunststoffen Bayblend T45 und Bayblend T65 (ABS/PC-Mischungen) wurden in einer 20 %-igen Lösung aus 2-(2-Ethoxyethoxy)-ethylacetat fünf Minuten lang bei 45 °C behandelt. Danach wurden sie in einer Lösung aus 100 g/l Natriumpermanganat und 10 g/l 96%-iger Schwefelsäure bei 50 °C zehn Minuten lang behandelt und wie in Beispiel 1 beschrieben nach dem Aktivieren chemisch reduktiv vernickelt und dann galvanisch verkupfert. Nach einer Stunde Lagern bei 80 °C wurden im Streifenabzugstest die in Tabelle 3 aufgeführten Werte der Haftfestigkeiten erhalten.

**Tabelle 3: Haftfestigkeiten einer Nickel-Kupfer-Schicht auf verschiedenen ABS/PC-Mischungen**

| **Bayblend** | **Haftfestigkeiten [N/mm]** | | |
|---|---|---|---|
| | **Front** | **Rückseite** | **Mittelwert** |
| T65 | 0.95 | 1.00 | 0.97 |
| T45 | 1.33 | 1.50 | 1.42 |

### Beispiel 6:

Platten aus Bayblend T45 wurden in einer 15%igen Lösung aus 2-(2-Ethoxyethoxy)-ethylacetat und 10% Butoxyethanol verschieden lange bei 45°C behandelt. Anschließend wurden die Platten fünf Minuten in saurer Permanganatlösung gebeizt, aktiviert und verkupfert, wie in Beispiel 1 beschrieben. Nach einer Stunde Lagern bei 80 °C wurden im Streifenabzugstest die Haftfestigkeiten bestimmt.

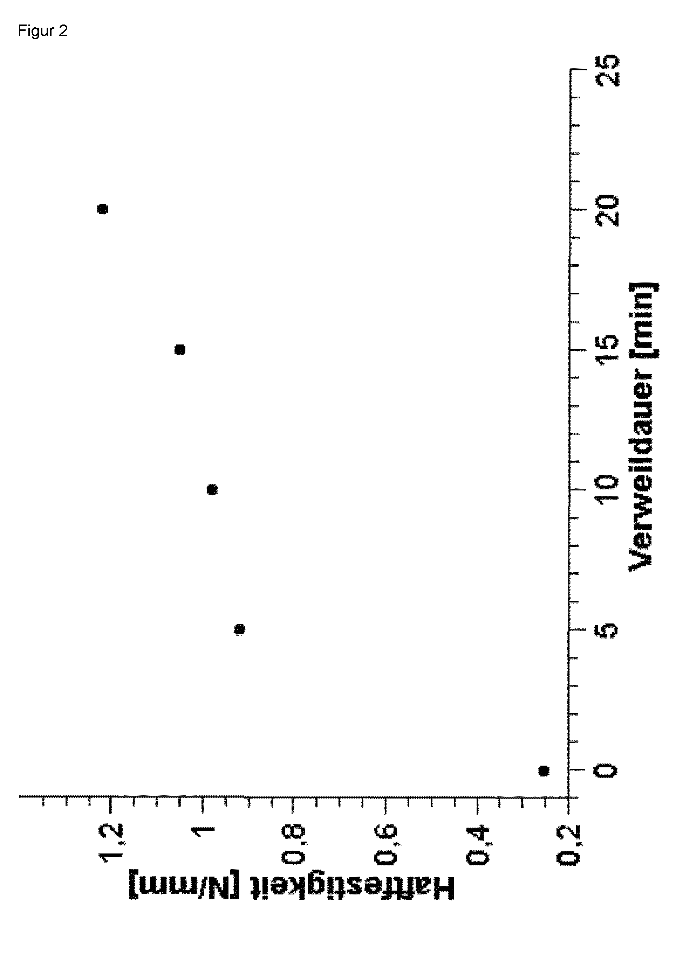

Die Haftfestigkeiten der Metallschicht sind in Figur 2 dargestellt. Die Verweildauer der Kunststoffoberflächen in der Lösung der Glykolverbindungen (Vorbehandlungsschritt) hat einen Einfluss auf die Haftfestigkeit der aufgebrachten Metallschichten. Ohne Behandlung mit Glykolverbindungen (Verweildauer 0 min in Figur 2) wurde lediglich eine Haftfestigkeit von 0,25 N/mm erhalten. Nach einer nur 5 minütigen Behandlung mit Glykolverbindungen dagegen wurde bereits eine gute Haftfestigkeit von 0,9 N/mm erzielt, die mit längerer Behandlungsdauer weiter ansteigt.

### Beispiel 7:

Platten aus ABS-Kunststoff (Novodur P2MC) wurden, wie in Beispiel 8 beschrieben, verschieden lange mit einer 15%igen Lösung aus 2-(2-Ethoxyethoxy)-ethylacetat und 10% Butoxyethanol behandelt, dem weiteren Metallisierungsverfahren unterworfen und die Haftfestigkeiten der aufgebrachten Metallschicht bestimmt.

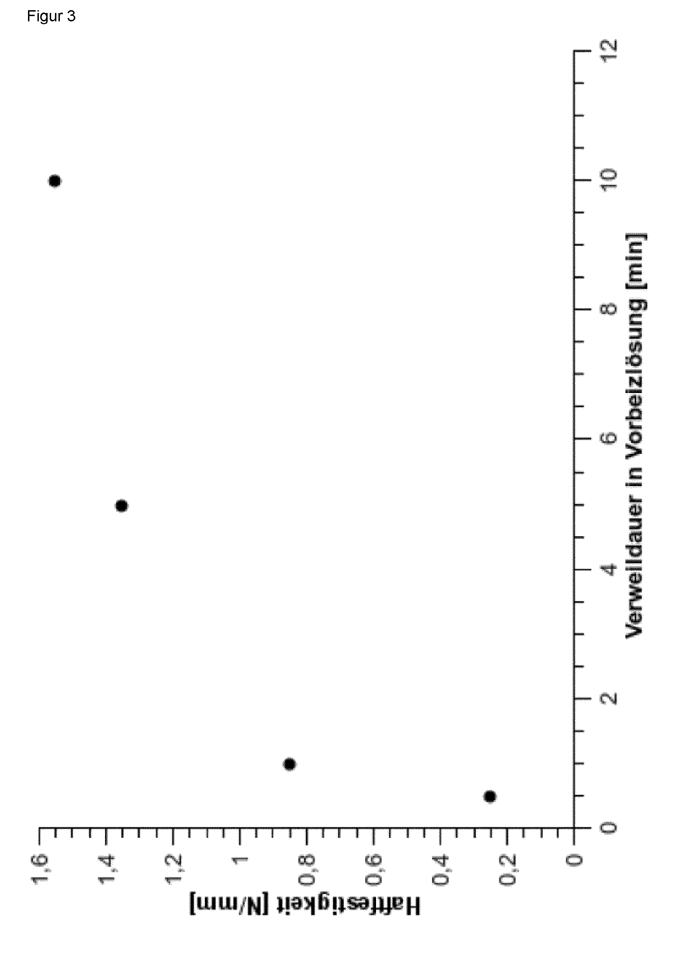

Die Haftfestigkeiten der Metallschicht in Abhängigkeit von der Behandlungsdauer mit der Lösung der Glykolverbindungen sind in Figur 3 dargestellt. Auch hier ist der Einfluss der Behandlungsdauer (in Figur 3 als Verweildauer in der Vorbeizlösung bezeichnet) auf die Haftfestigkeit der aufgebrachten Metallschichten klar ersichtlich. Ohne Behandlung mit Glykolverbindungen (Verweildauer 0 min in Figur 3) wurde lediglich eine Haftfestigkeit von 0,25 N/mm erhalten. Nach einer nur 5 minütigen Behandlung mit Glykolverbindungen dagegen wurde bereits eine sehr gute Haftfestigkeit von 1,4 N/mm erzielt, die mit längerer Behandlungsdauer weiter ansteigt.

## Patentansprüche

1. Verfahren zum Metallisieren von elektrisch nichtleitenden Kunststoffoberflächen von Gegenständen, umfassend die Verfahrensschritte:
A) Beizen der Kunststoffoberfläche mit einer Beizlösung,
B) Behandeln der Kunststoffoberfläche mit einer Lösung eines Metall-Kolloids oder einer Verbindung eines Metalls, wobei das Metall ausgewählt ist aus den Metallen der 1. Nebengruppe des Periodensystems der Elemente und der VIII. Nebengruppe des Periodensystems der Elemente, und
C) Metallisieren der Kunststoffoberfläche mit einer Metallisierungslösung;
**dadurch gekennzeichnet, dass** die Beizlösung eine Quelle für Permanganationen enthält

2. Verfahren nach Anspruch 1, **dadurch gekennzeichnet, dass** vor Verfahrensschritt A) folgender weiterer Verfahrensschritt durchgeführt wird:
Vorbehandlungsschritt: Behandeln der Kunststoffoberfläche in einer wässrigen Lösung enthaltend mindestens eine Glykolverbindung.

3. Verfahren nach Anspruch 2, **dadurch gekennzeichnet, dass** die mindestens eine Glykolverbindung ausgewählt wird aus Verbindungen gemäß allgemeiner Formel (I) 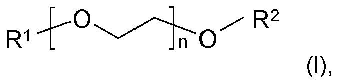 worin
n eine ganze Zahl zwischen 1 und 4 bedeutet; und
R¹ und R² unabhängig voneinander bedeuten -H, -CH₃, -CH₂-CH₃, -CH₂-CH₂-CH₃, -CH(CH₃)-CH₃, -CH₂-CH₂-CH₂-CH₃, -CH(CH₃)-CH₂-CH₃, -CH₂-CH(CH₃)-CH₃, -CH₂-CH₂-CH₂-CH₂-CH₃, -CH(CH₃)-CH₂-CH₂-CH₃, -CH₂-CH(CH₃)-CH₂-CH₃, -CH₂-CH₂-CH(CH₃)-CH₃, -CH(CH₂-CH₃)-CH₂-CH₃, -CH₂-CH(CH₂-CH₃)-CH₃, -CO-CH₃, -CO-CH₂-CH₃, -CO-CH₂-CH₂-CH₃, -CO-CH(CH₃)-CH₃, -CO-CH(CH₃)-CH₂-CH₃, -CO-CH₂-CH(CH₃)-CH₃, -CO-CH₂-CH₂-CH₂-CH₃.

4. Verfahren nach einem der vorstehenden Ansprüche, **dadurch gekennzeichnet, dass** die Quelle für Permanganationen in der Beizlösung gemäß Verfahrensschritt A) ausgewählt wird aus der Gruppe von Alkalimetall-Permanganaten enthaltend Kaliumpermanganat und Natriumpermanganat.

5. Verfahren nach einem der vorstehenden Ansprüche, **dadurch gekennzeichnet, dass** die Quelle für Permanganationen in der Beizlösung gemäß Verfahrensschritt A) in einer Konzentration zwischen 30 g/l - 250 g/l vorliegt.

6. Verfahren nach einem der vorstehenden Ansprüche, **dadurch gekennzeichnet, dass** die Beizlösung gemäß Verfahrensschritt A) weiter eine anorganische Säure enthält.

7. Verfahren nach Anspruch 6, **dadurch gekennzeichnet, dass** die anorganische Säure in der Beizlösung gemäß Verfahrensschritt A) in einer Konzentration von 0,02 - 0,6 mol/l bezogen auf eine einbasige Säure vorliegt.

8. Verfahren nach einem der vorstehenden Ansprüche, **dadurch gekennzeichnet, dass** die Kunststoffoberfläche aus mindestens einem elektrisch nichtleitenden Kunststoff gefertigt ist und der mindestens eine elektrisch nichtleitende Kunststoff ausgewählt ist aus der Gruppe enthaltend ein Acrylnitril-Butadien-Styrol-Copolymer, ein Polyamid, ein Polycarbonat und eine Mischung eines Acrylnitril-Butadien-Styrol-Copolymers mit mindestens einem weiteren Polymer.

9. Verfahren nach einem der vorstehenden Ansprüche, **dadurch gekennzeichnet, dass** zwischen den Verfahrensschritten A) und B) folgender weiterer Verfahrensschritt durchgeführt wird:
A i) Behandeln der Kunststoffoberfläche in einer Lösung enthaltend ein Reduktionsmittel für Mangandioxid.

10. Verfahren nach Anspruch 9, **dadurch gekennzeichnet, dass** das Reduktionsmittel für Mangandioxid ausgewählt wird aus der Gruppe enthaltend Hydroxylammoniumsulfat, Hydroxylammoniumchlorid und Wasserstoffperoxid.

11. Verfahren nach einem der vorstehenden Ansprüche, **dadurch gekennzeichnet, dass** zwischen den Verfahrensschritten B) und C) folgende weitere Verfahrensschritte durchgeführt werden:
B i) Behandeln der Kunststoffoberfläche in einer wässrigen sauren Lösung und
B ii) Stromloses Metallisieren der Kunststoffoberfläche in einer Metallisierungslösung.
